# EUROPEAN PATENT SPECIFICATION

(11) **EP 2 156 718 B1**
(45) Date of publication and mention of the grant of the patent: **03.06.2015**
(21) Application number: 07727732.5
(22) Date of filing: 03.04.2007
(51) Int. Cl.: H05K 7/14

(54) **BACKPLANE TO MATE BOARDS WITH DIFFERENT WIDTHS**
RÜCKWAND ZUR VERBINDUNG VON PLATTEN MIT VERSCHIEDENEN BREITEN
FOND DE PANIER PERMETTANT D'ACCOUPLER DES CARTES DE LARGEURS DIFFÉRENTES

(43) Date of publication of application: 24.02.2010
(73) Proprietor: Optis Wireless Technology, LLC, Plano, TX 75025 (US)
(72) Inventor: RIMBORG, Mats, S-416 53 Göteborg (SE)
(74) Representative: Grünecker Patent- und Rechtsanwälte PartG mbB
(86) International application number: PCT/EP2007/053261
(87) International publication number: WO 2008/119393

(56) References cited:
- EP-A- 0 691 704
- WO-A-98/46057
- WO-A-02/054847
- FR-A- 2 764 472

## Description

### TECHNICAL FIELD

The invention relates to the technical field of backplanes for electronic assembly magazines.

### BACKGROUND

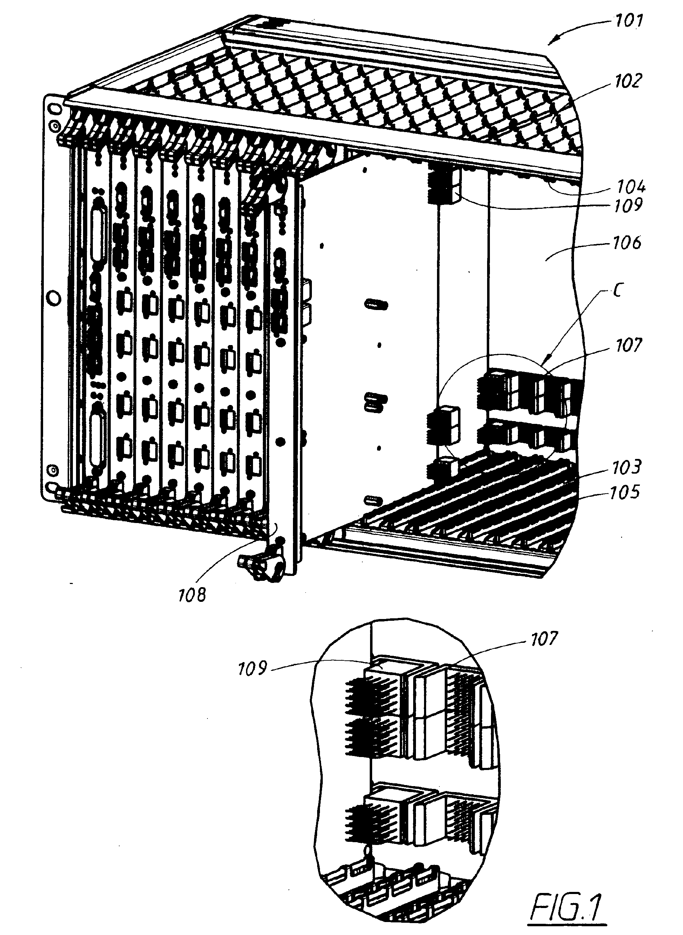

The hardware of electronic systems such as e.g. telecommunications systems comprises a number of circuit board assemblies. Based on the technology of today these boards are typically mounted in magazines having horizontal shelves. Figure 1 shows a magazine 101 with a top shelf 102, a bottom shelf 103, top rails 104 and bottom rails 105 and a backplane 106 with sockets 107. When the circuit board assembly 108 is inserted in the magazine it is guided through the top and bottom rails towards a socket 107 mounted to the backplane. The circuit board assembly has a plug 109 at an edge portion of the circuit board assembly. The plug and socket are shown more in detail in the enlarged section C in figure 1. The rails are located in relation to the socket or sockets at the back plane such that the plug is guided to mate with the socket or sockets and thus establishing an electrical contact between the circuit board assembly and the backplane. The backplane includes electrical connections to allow for communications between the circuit board assemblies in the magazine and communications with other parts of the telecommunications system.

Figure 2 shows how to arrange for further guidance of the circuit board assembly 108 towards the socket. The plug 201 is supplied with ribs 202 at each side which are adapted to mate with corresponding slots 203 at the inner side walls of the socket 204.

Figure 3 shows the backplane 301 with vertical stripes of sockets 302. The enlarged section A shows the sockets 303 and connector pins 304.

Backplane designs following different standards such as VME (Versa Module Eurocard), cPCI (Compact Peripheral Component Interconnect) and ATCA (Advanced Telecom Computing Architecture) have traditionally been designed with a fixed distance between the boards, e.g. 20,32 mm (0,8 inch) for VME and cPCI and 30,48 mm (1,2 inch) for ATCA.

The optimal board width varies depending on what's mounted on the board and the amount of power and cooling required. A simple interface board may only need a 10 mm slot, a CPU (Central Processing Unit) board can be fitted in a 15 mm slot, if PMC (Peripheral component interconnect Mezzanine Card) adapters are used 20 mm is more suitable, and for boards with AMC ( Advanced Mezzanine Card) adapters 25 mm is needed. A slot is defined as the width required for a certain circuit board assembly.

When the backplane basic board width has been decided all board widths must be adapted to a multiple of this value, and regardless of what is chosen it will never be optimal for all designs. Different boards will not be able to coexist in the same magazine unless they are designed for the same basic board width. This basic board width is henceforth called the pitch for the backplane. If a pitch of 15 mm is chosen for a backplane this means that all boards belonging to the magazine with this backplane have to have a width being a multiple of 15 i.e. 15, 30, 45 ...millimetres.

A sufficiently small pitch, such as 5 mm, may in theory be used to overcome this problem, but in practice the sockets needed to implement this design will be very narrow, and the number of connections to each possible board position, whether they are used or not, will be unnecessarily large. For practical reasons this solution is not useful.

Hence there is a need to accommodate circuit board assemblies with a greater flexibility in using different widths within the same magazine in order to accomplish efficient use of the magazine space available.

WO 98/46057 discloses a backplane for a magazine having the features of the preamble portion of claim 1.

### SUMMARY

It is therefore the objective of the invention to provide a backplane for a magazine according to claim 1, as well as a magazine and a method for arranging sockets, which can solve the problem to conveniently accommodate circuit board assemblies with different widths within the same magazine.

This object is achieved by a backplane having the features disclosed in the caracterizing portion of claim 1.

Instead of placing the backplane sockets in stripes parallel to the circuit board surfaces, mating one board per stripe, the idea is to position the stripes of sockets perpendicular to the circuit board surfaces and be able to mate boards with different widths to a wider or narrower part of one or several stripes in a flexible manner. Each circuit board assembly can have several plugs along a rear edge of the board, each plug mating with a stripe of sockets being perpendicular to the circuit board surfaces.

For telecommunications equipment the backplane may provide connections to for example:
- Redundant 48 V power supply
- Redundant 10/100/1000 Mbps Ethernet for control and/or payload
- One ore several redundant 10 Gbps Ethernet for payload
- IPMI (Intelligent Platform Management Interface)

The list is not exhaustive.

Connections to different resources may be repeated with different intervals. Power needs to be available within every basic circuit board assembly width i.e. within the selected pitch, but 10 Gbps Ethernet can for most cases be limited to every second or every third pitch. This is an implementation decision within the scope of the invention.

A certain pitch has to be decided for each backplane and is fixed for each backplane. However the pitch defines the basic circuit board assembly width and hence the smallest width possible for the circuit board assembly. If a pitch of 5 mm is selected then the circuit board assemblies can have widths or slot sizes which are multiples of 5 mm, i.e. 5, 10, 15, 20 ...and they can be mixed arbitrarily within the same magazine.

All available space within a magazine with a backplane with flexible slot size may be used efficiently regardless of how different board types are combined. This makes it possible to create compact solutions with a minimal infrastructure overhead such as power supplies, chassis and interconnections.

Further advantages are achieved if the invention also is given one or several of the characteristics of the dependent claims such as e.g.
- equal distance between contact points in a direction perpendicular to the circuit board surfaces
- the contact points in the sockets are realized as male or female contacts
- creating one or several stripes of sockets in a direction perpendicular to the circuit board surfaces and extending over part of the width of the backplane or along the full width of the backplane.
- board positions for communication switch boards are allocated in the middle of the magazine
- communication boards are according to Ethernet standard
- the plugs have ribs, on each side perpendicular to the circuit board surfaces, which are adapted to mate with corresponding slots at inner sides of side walls of the sockets
- power supply to the circuit board assembly is arranged by connecting two rows of connector pins with strips of a conductive material such as copper
- IPMI (Intelligent Platform Management Interface) connection is arranged in a similar way as the power supply.

### BRIEF DESCRIPTION OF THE DRAWINGS

Figure 1 schematically shows a perspective view of a prior art magazine

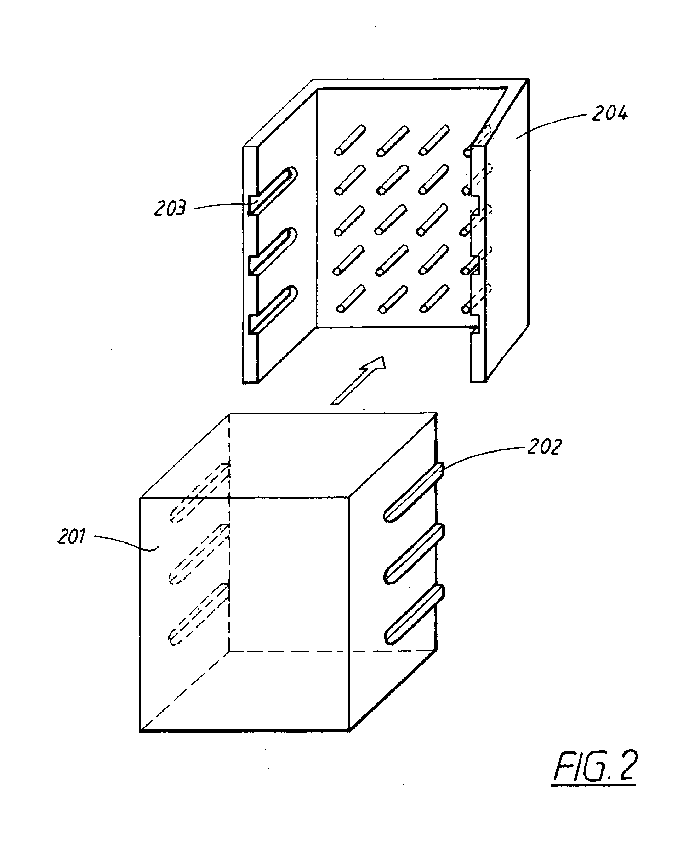

Figure 2 schematically shows a plug and socket with guiding means according to prior art.

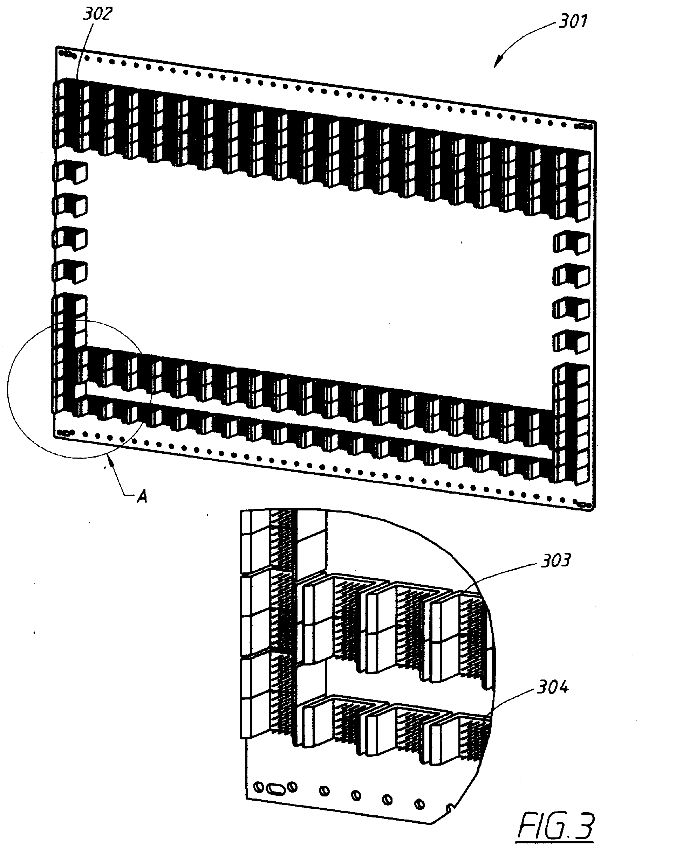

Figure 3 schematically shows a perspective view of a backplane according to prior art.

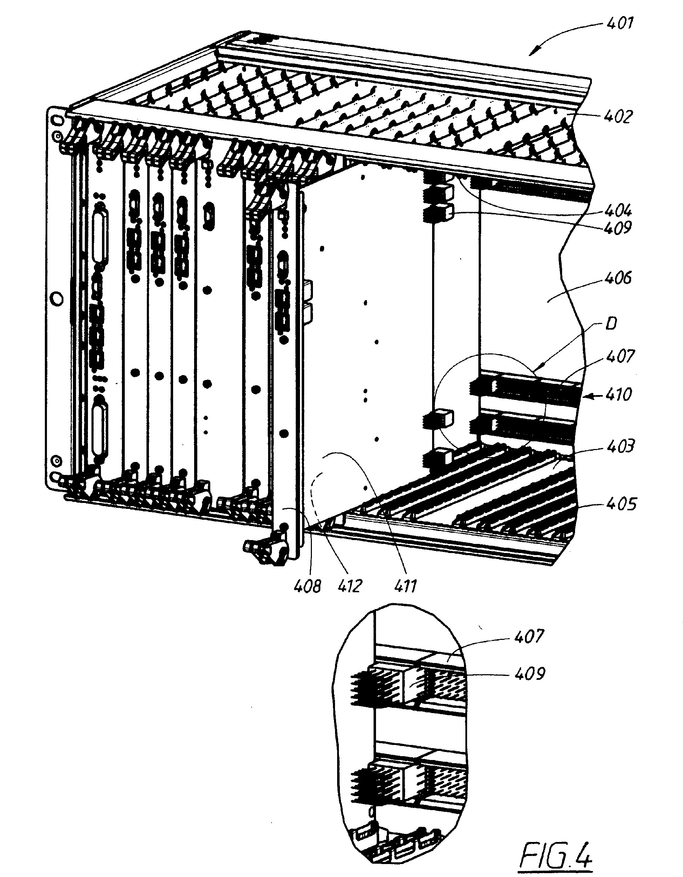

Figure 4 schematically shows a magazine with a backplane according to the invention.

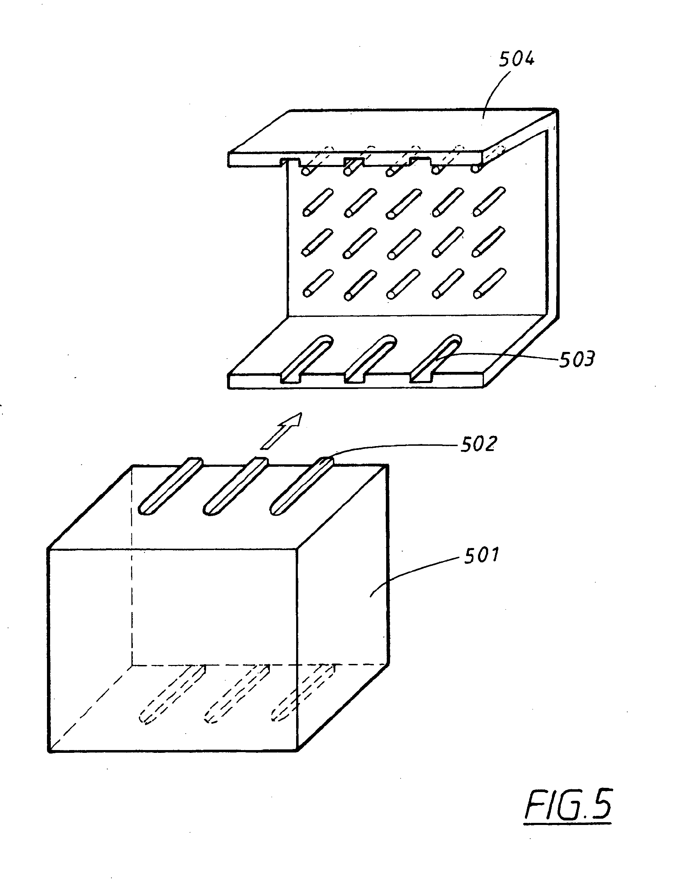

Figure 5 schematically shows a plug and socket with guiding means according to the invention.

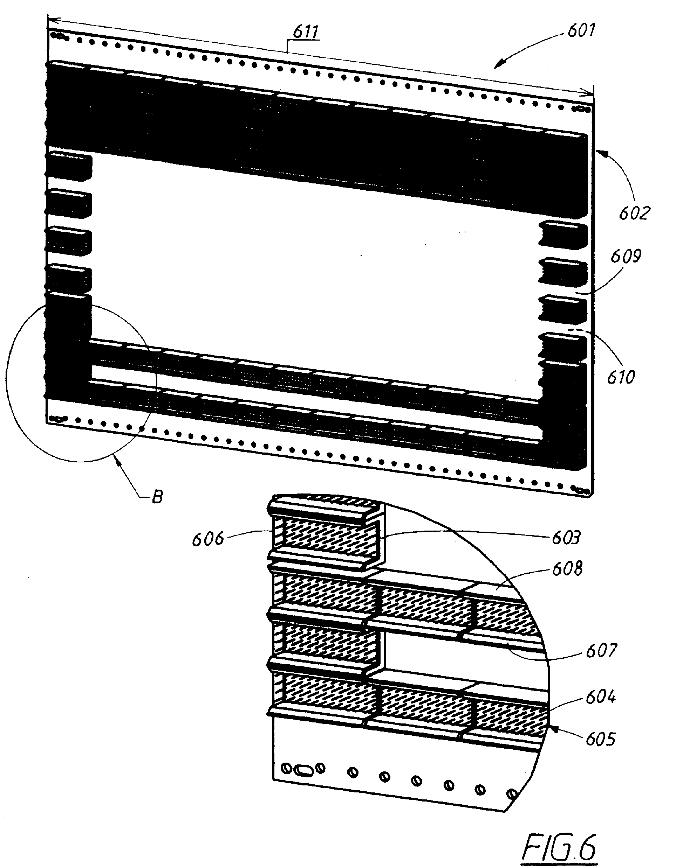

Figure 6 schematically shows a perspective view of a backplane according to the invention.

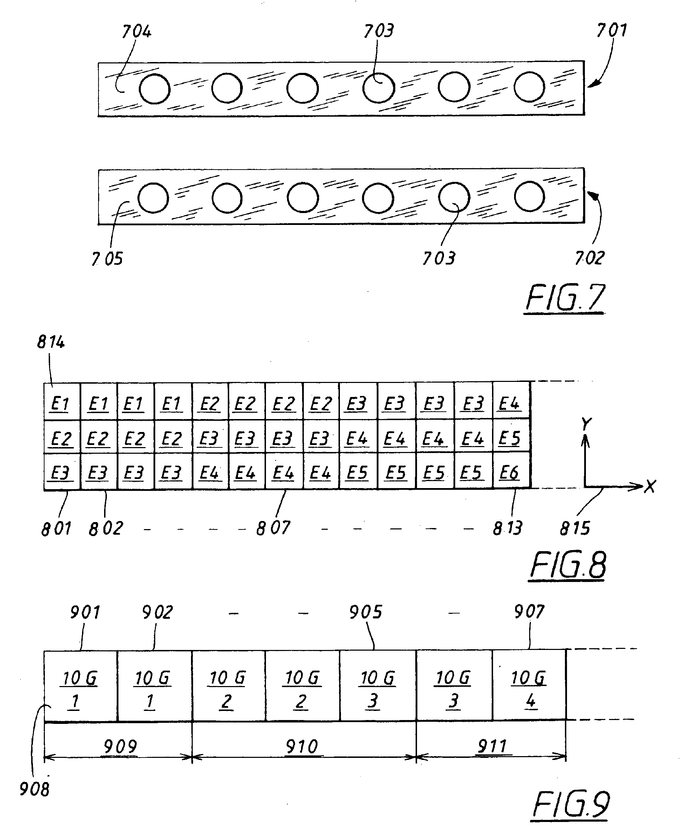

Figure 7 schematically shows an arrangement for power supply distribution to the circuit board assemblies.
Figure 8 schematically shows an example of how to allocate 10/100/1000 Mbps Ethernet connections.
Figure 9 schematically shows an example of how to implement 10 Gbps Ethernet connections.

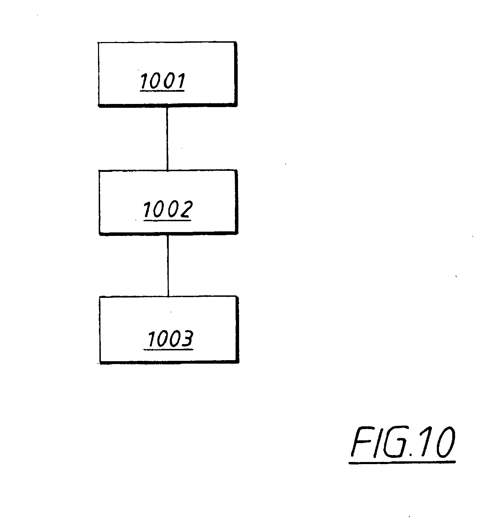

Figure 10 schematically shows a method how to arrange sockets on a backplane.

### DETAILED DESCRIPTION

The invention will in the following be described in detail with reference to the drawings.

A backplane according to the invention is described in figure 4 which shows a magazine 401 with a top shelf 402, a bottom shelf 403, top rails 404 and bottom rails 405 and a backplane 406 with sockets 407. When a circuit board assembly 408 is inserted in the magazine it is guided through the top and bottom rails towards the socket 407 mounted to the backplane. The circuit board assembly has a plug 409 at an edge portion of the circuit board assembly. The plug and the socket are shown more in detail in enlarged section D in figure 4. The rails are located in relation to the socket or sockets at the back plane such that the plug is guided to mate with the socket or sockets and thus establishing an electrical contact between the circuit board assembly and the backplane. The circuit board assembly has a first circuit board surface 411 and an opposite second circuit board surface 412. The backplane, which e.g. can be manufactured as a conventional Printed Circuit Board (PCB), includes electrical connections, in one or several layers, to allow for communications between the circuit board assemblies in the magazine and communications with other parts of the telecommunications system. The backplane can e.g. be manufactured by glass fibre reinforced epoxy, such as FR-4.

Figure 5 shows how to arrange for further guidance of the circuit board assembly 408 towards the socket 504. The plug 501 is supplied with ribs 502 at each side which are adapted to mate with corresponding slots 503 at inner side walls of the socket 504.

The backplane 406 can have one or several stripes 410 of sockets 407 in a direction perpendicular to the first circuit board surface 411 and the second circuit board surface 412. The distance between the stripes is adapted to the needs for the intended application. The stripes can be located as close to each other as allowed by the physical design of the sockets. The distance between the plugs on the rear edge of the circuit board assembly has to be designed so as to fit into the socket locations on the backplane.

Figure 6 shows the backplane 601 with stripes 602 of sockets 603 in a direction perpendicular to the first circuit board surface 411 and the second circuit board surface 412. The enlarged section B shows rows 605 of contact points 604, in the direction perpendicular to the first circuit board surface 411 and the second circuit board surface 412. In this example the contact points are realized as connector pins. The enlarged section B also shows the sockets 603, short ends 606 and side walls 607 and 608 of the socket 603. The backplane has a width 611, a first backplane surface 609 and an opposite second backplane surface 610.

A practical basic circuit board assembly width or pitch, can be 5 mm. In the description connector points in the socket are henceforth exemplified with connector pins even if also female contact points may be used. The spacing between the connector pins, in a direction perpendicular to the first circuit board surface 411 and the second circuit board surface 412, must be adapted to the pitch. If the pitch is 5 mm the connector pin spacing can be 5/1=5,0 mm, 5/2=2,5 mm, 5/3=1,67 mm, 5/4=1,25 mm or 5/5=1,0 mm. Wider spacing may be desirable for power supply pins and closer spacing for data signals. The spacing between the connector pins, in the direction perpendicular to the first circuit board surface 411 and the second circuit board surface 412, within a socket/s or a stripe/s on the backplane is normally the same, i.e. the backplane has normally a fixed spacing between connector pins in this direction. The spacing between connector pins, in a direction parallel to the first circuit board surface 411 and the second circuit board surface 412, within a socket is normally the same as the spacing in the direction perpendicular to the first circuit board surface 411 and the second circuit board surface 412 but may also be different. Within a stripe of sockets the distance between connector pins, in the direction parallel to the first circuit board surface 411 and the second circuit board surface 412, is usually constant but may also differ from socket to socket depending on how the magazine is equipped with different types of circuit board assemblies having different types of plugs. The thickness of the connector pins are typically the same within a stripe of sockets but may vary from row to row and socket to socket.

The magazine has a number of possible board positions depending on the selected pitch. If a magazine has an effective width of 300 mm and a pitch of 5 mm, the magazine has 60 possible board positions. If the magazine is equipped only with circuit board assemblies with a width of 10 mm, the magazine can hold 30 boards, each board taking up two positions.

The backplane normally has two redundant predefined locations reserved for communication switch boards, henceforth exemplified with Ethernet, to provide connectivity within the magazine, just like any other modern fixed slot size backplane. Ethernet is a common communication protocol used in the ATCA standard (Advanced Telecom Computing Architecture). However other communication protocols as e.g. PCI Express (Peripheral Component Interconnect) or RapidlO may be used. The predefined locations for the Ethernet switch boards are in the middle of the magazine according to the ATCA standard. Other standards can have other predefined Ethernet switch board positions. If an Ethernet board with a width of 15 mm is used and the backplane has a pitch of 5 mm, each Ethernet board will take up three board positions of the magazine.

Each position is identifiable by means of a unique bit pattern. This could be achieved by coding a binary, parity checked, data word at each possible board position of the backplane by using a combination of a number of grounded and ungrounded connector pins, unique for each board position.

Each board within a magazine should receive an input with information about the number of board positions, counted from one side of the magazine, which have been used. Each board should also forward information to the next one about which board positions it has used itself, i.e. increment the received number by one, or possibly more in case of a complex board which utilizes more than one board position. If the backplane contains a control bus, such as IPMI (Intelligent Platform Management Interface), it could be used to transfer this information.

Unused board positions should need no external electrical terminations, and the connection information should be passed through such slots passively.

The mechanical guide rails for the circuit boards assemblies must have the same spacing as the backplane pitch. Special consideration should be taken when designing this to allow adequate air flow for cooling to pass through them. The rails and the top and bottom shelves can e.g. be perforated.

Figure 7 shows how the power supply to the circuit board assemblies in the magazine can conveniently be arranged by connecting two rows 701 and 702 of connector pins 703 with broad strips 704 and 705 of a conductive material as e.g. copper, each strip connecting one row of connector pins.

The communication internally within the magazine and externally can be arranged through e.g Ethernet, PCI Express (Peripheral Component Interconnect) or RapidlO. Each circuit board assembly 408 normally has a connection to a communication means here exemplified by Ethernet. Some circuit boards might only pick up power supply from the backplane and external communication is arranged by means of connectors at the front panel of the circuit board assembly. In order to save connector pins, various solutions are possible. The solutions are based on that not all possible board positions have available Ethernet connections. A standard Ethernet connection for 10/100/1000 Mbps (Megabits per second) requires 8 contact pins on the socket. A 300 mm magazine with 5 mm pitch has 60 board positions. If an Ethernet connection should be available at each position it would require 60x8=480 connector pins only for Ethernet connections.

Another way is to use the information about the number of boards and the average widths of the boards together with the physical position and use this to select one connection out of several available at each position. In this case a selected number of connections are available for the whole magazine, and as long as not all narrow boards are placed to one side and all wide boards to the other side it will be possible to select a separate connection for each used board position. Figure 8, which can be imagined to extend further to the right, shows 13 board positions 801-813, each board position has a width of 5 mm, i.e. the pitch is 5 mm. Each square 814 at a board position has 8 connections. With a connector pin distance of 5/4=1,25 mm, the pins can be arranged in two rows with 4 pins/row. The squares are arranged in a matrix in an x/y plane defined by coordinate symbol 815. Squares 1/3-4/3 has access to an Ethernet 1 connection, 1/2-4/2 Ethernet 2, 1/1-4/1 to Ethernet 3 and so on. If 10 mm boards are used they will require two board positions each. Board nr 1 will require board position 1 and 2 and can use Ethernet 1, board nr 2 requires positions 3 and 4 and can use Ethernet connection nr 2 and so on. Board nr 5 will use positions 9 and 10 and Ethernet 5. When it comes to board nr 6 it will not find a free Ethernet connection as can be seen in figure 8. Board nr 6 has to have a width of 15 mm to be able to pick up Ethernet connection nr 6. This solution will limit the flexibility for Ethernet connections but it will save connector pins needed and it will have sufficient flexibility for most practical applications when boards of different widths are mixed. This is just an illustration of one possible solution. Many other solutions are of course possible within the scope of the invention.

10 Gbps (Gigabits per second) Ethernet could be implemented similarly to 10/100/1000 Mbps Ethernet. Figure 9 shows the same 10 Gbps Ethernet port connected to two adjacent positions, and three boards of different widths use one Ethernet port each. Figure 9 also shows 7 board positions 901-907, each position of 5 mm width. Each square 908 has 16 connector pins which is required for 10 Gbps when 10 Gbase CX-4 standard is used. Board no 1 has a width of 10 mm, distance 909, and can use 10G no 1, board 2 has a width of 15 mm, distance 910, and can use 10G no 2, board 3 has a width of 10 mm, distance 911, and can use 10G no 3, and so on. (10 Gbase-T standard only requires 8 connector pins but has other limitations)

The IPMI (Intelligent Platform Management Interface) standard defines a set of common interfaces used to monitor system status and to manage the system. IPMI is a multidrop I² C (Inter-integrated circuit) based architecture and could easily be implemented in the same way as the power supply as described in association with figure 7 above. In this case the conductive strips can be made narrower as very low power is needed.

If circuit board assemblies, designed for use with a backplane with stripes of sockets in the direction parallel to the first circuit board surface 411 and the second circuit board surface 412, is desired to be used together with the backplane according to the invention this can be solved by increasing the depth of the magazine and insert an adapter between the circuit board assembly and the backplane. The adapter contains logics and mechanical adjustments needed for the conversion.

Figure 10 schematically illustrates a method of arranging 1001 sockets on a backplane. The sockets are mounted 1002 short end to short end with side walls aligned 1003 in the direction perpendicular to the first circuit board surface 411 and the second circuit board surface 412 thus creating at least one stripe of sockets in the direction perpendicular to the first circuit board surface 411 and the second surface board surface 412. The stripe can extend along the full width 611 of the backplane or part of the width 611 of the backplane.

The invention has been described for applications within the telecommunications field but can e.g. also be used within the field of computers and any other field within electronics where there is a need for a backplane to connect a number of circuit board assemblies.

The invention is not limited to the embodiments above, but may vary freely within the scope of the appended claims.

## Claims

1. A backplane (406, 601) for a magazine (401), the backplane comprising a first backplane surface (609) and an opposite second backplane surface (610), the backplane being equipped with sockets (407, 504, 603) on the first backplane surface (609), the sockets having a number of contact points (604, 703) and are arranged to receive a mating plug (409, 501), mounted at a rear edge of a circuit board assembly (408) for establishing an electrical contact between the circuit board assembly and the backplane, the circuit board assembly having a certain width and having a first circuit board surface (411) and an opposite second circuit board surface (412), both circuit board surfaces being perpendicular to the backplane, and further that the sockets are arranged such as to accomplish rows (605) of the contact points being perpendicular to the first circuit board surface (411) and the second circuit board surface (412), the sockets (407, 504, 603) having open short ends (606) and two side walls (607, 608) along each longitudinal side of the socket and at least one row of connector pins (605) between the side walls (607, 608), **characterized in that** the sockets being mounted short end to short end with the side walls aligned perpendicular to the first circuit board surface (411) and the second circuit board surface (412) thus creating at least one stripe (410, 602) of sockets in a direction perpendicular to the first circuit board surface (411) and the second circuit board surface (412).

2. A backplane according to claim 1, **characterized i n** that the at least one stripe (410, 602) of sockets extend along part of a width (611) of the backplane or along the full width of the backplane.

3. A backplane according to claim 1 or 2, **characterized in that** there is an equal distance between the contact points (604, 703) in a direction perpendicular to the first circuit board surface (411) and the second circuit board surface (412).

4. A backplane according to any of claims 1-3, **characterized i n** that the contact points (604, 703) in the sockets (407, 504, 603) are realized as male contacts or contact pins.

5. A backplane according to any of claims 1-3, **characterized i n** that the contact points (604, 703) in the sockets (407, 504, 603) are realized as female contacts.

6. A backplane according to any of the preceding claims, **characterized i n** that the width of the circuit board assemblies (408) within a magazine (401) can vary within the limitation of being a multiple of a selected pitch, being a basic width of the circuit board assembly.

7. A backplane according to any of the preceding claims, **characterized i n** that board positions (801-813, 901-907) for two communication switch boards are allocated in the middle of the magazine, one of which is redundant.

8. A backplane according to claim 7, **characterized i n** that the communication boards are made according to the Ethernet standard.

9. A backplane according to any of the preceding claims, **characterized in that** the plugs (409, 501) have ribs (502) on each side, perpendicular to the first circuit board surface (411) and the second circuit board surface (412), which are adapted to mate with corresponding slots (503) at inner sides of the side walls (607, 608) to the socket (407, 504, 603).

10. A backplane according to any of the preceding claims, **characterized i n** that power supply to the circuit board assemblies (408) is arranged by connecting two rows (701) and (702) of the connector pins (604, 703) with broad strips (704, 705) of a conductive material, each strip connecting one row of connector pins.

11. A backplane according to claim 10, **characterized i n** that the conductive material is copper.

12. A backplane according to any of the preceding claims, **characterized i n** that IPMI connection to the circuit board assemblies (408) is arranged by connecting two rows (605) of the connector pins (604, 703) with strips of a conductive material, each strip connecting one row of connector pins.

13. A magazine (401), **characterized in that** it is equipped with a backplane (406, 601) according to any one of the preceding claims.

14. A method for arranging (1001) sockets (407, 504, 603) on a backplane (406, 601), **characterized i n** that the sockets are mounted (1002) short end (606) to short end with side walls (607, 608) aligned perpendicular (1003) to the first circuit board surface (411) and the second circuit board surface (412) thus creating at least one stripe (410, 602) of sockets, extending along part of the width of the backplane or along the full width of the backplane, in a direction perpendicular to the first circuit board surface (411) and the second circuit board surface (412).

## Patentansprüche

1. Rückwand (406, 601) für ein Magazin (401), wobei die Rückwand eine erste Rückwandoberfläche (609) und eine gegenüberliegende zweite Rückwandoberfläche (610) umfasst, die Rückwand mit Sockeln (407, 504, 603) auf der ersten Rückwandoberfläche (609) ausgestattet ist, die Sockel eine Anzahl von Kontaktpunkten (604, 703) haben und dazu eingerichtet sind, einen passenden Stecker (409, 501) aufzunehmen, der an einem hinteren Rand einer Schaltplatinenanordnung (408) angebracht ist, um einen elektrischen Kontakt zwischen der Schaltplatinenanordnung und der Rückwand herzustellen, die Schaltplatinenanordnung eine bestimmte Breite hat und eine erste Schaltplatinenoberfläche (411) und eine gegenüberliegende zweite Schaltplatinenoberfläche (412) hat, beide Schaltplatinenoberflächen senkrecht zu der Rückwand sind und weiterhin die Sockel derart angeordnet sind, dass Reihen (605) der Kontaktpunkte senkrecht zu der ersten Schaltplatinenoberfläche (411) und der zweiten Schaltplatinenoberfläche (412) sind, wobei die Sockel (407, 504, 603) offene kurze Enden (606) und zwei Seitenwände (607, 608) entlang jeder Längsseite des Sockels und wenigstens eine Reihe von Verbinderstiften (605) zwischen den Seitenwänden (607, 608) haben, **dadurch gekennzeichnet, dass** die Sockel kurzes Ende an kurzem Ende angeordnet sind, wobei die Seitenwände senkrecht zu der ersten Schaltplatinenoberfläche (411) und der zweiten Schaltplatinenoberfläche (412) ausgerichtet sind, so dass wenigstens ein Streifen (410, 602) von Sockeln in einer Richtung senkrecht zu der ersten Schaltplatinenoberfläche (411) und der zweiten Schaltplatinenoberfläche (412) erzeugt ist.

2. Rückwand nach Anspruch 1, **dadurch gekennzeichnet, dass** sich der wenigstens eine Streifen (410, 602) von Sockeln entlang eines Teils der Breite (611) der Rückwand oder entlang der vollen Breite der Rückwand erstreckt.

3. Rückwand nach Anspruch 1 oder 2, **dadurch gekennzeichnet, dass** der Abstand zwischen den Kontaktpunkten (604, 703) in einer Richtung senkrecht zu der ersten Schaltplatinenoberfläche (411) und der zweiten Schaltplatinenoberfläche (412) gleich ist.

4. Rückwand nach einem der Ansprüche 1 bis 3, **dadurch gekennzeichnet, dass** die Kontaktpunkte (604, 703) in den Sockeln (407, 504, 603) als Steckerkontakte oder Kontaktstifte realisiert sind.

5. Rückwand nach einem der Ansprüche 1 bis 3, **dadurch gekennzeichnet, dass** die Kontaktpunkte (604, 703) in den Sockeln (407, 504, 603) als Buchsenkontakte realisiert sind.

6. Rückwand nach einem der vorhergehenden Ansprüche, **dadurch gekennzeichnet, dass** die Breite der Schaltplatinenanordnungen (408) innerhalb eines Magazins (401) mit der Einschränkung eines Vielfachen eines gewählten Teilungsabstandes variieren kann, der eine Basisbreite der Schaltplatinenanordnung ist.

7. Rückwand nach einem der vorhergehenden Ansprüche, **dadurch gekennzeichnet, dass** Platinenpositionen (801-813, 901-907) für zwei Kommunikations-Schalterplatinen in der Mitte des Magazins angeordnet sind, von denen eine redundant ist.

8. Rückwand nach Anspruch 7, **dadurch gekennzeichnet, dass** die Kommunikationsplatinen gemäß dem Ethernet-Standard gefertigt sind.

9. Rückwand nach einem der vorhergehenden Ansprüche, **dadurch gekennzeichnet, dass** die Stecker (409, 501) Rippen (502) auf jeder Seite haben, die senkrecht zu der ersten Schaltplatinenoberfläche (411) und der zweiten Schaltplatinenoberfläche (412) sind und dazu eingerichtet sind, in entsprechende Schlitze (503) auf Innenseiten der Seitenwände (607, 608) an dem Sockel (407, 504, 603) zu passen.

10. Rückwand nach einem der vorhergehenden Ansprüche, **dadurch gekennzeichnet, dass** die Stromversorgung für die Schaltplatinenanordnungen (408) durch Verbinden von zwei Reihen (701) und (702) der Verbinderstifte (604, 703) mit breiten Streifen (704, 705) eines leitfähigen Materials eingerichtet ist, wobei jeder Streifen eine Reihe von Verbinderstiften verbindet.

11. Rückwand nach Anspruch 10, **dadurch gekennzeichnet, dass** das leitfähige Material Kupfer ist.

12. Rückwand nach einem der vorhergehenden Ansprüche, **dadurch gekennzeichnet, dass** eine IPMI-Verbindung zu den Schaltplatinenanordnungen (408) durch Verbinden zweier Reihen (605) der Verbinderstifte (604, 703) mit Streifen eines leitfähigen Materials eingerichtet ist, wobei jeder Streifen eine Reihe von Verbinderstiften verbindet.

13. Magazin (401), **dadurch gekennzeichnet, dass** es mit einer Rückwand (406, 601) nach einem der vorhergehenden Ansprüche ausgestattet ist.

14. Verfahren zum Anordnen (1001) von Sockeln (407, 504, 603) auf einer Rückwand (406, 601), **dadurch gekennzeichnet, dass** die Sockel kurze Seite (606) an kurzer Seite angebracht werden (1002), wobei die Seitenwände (607, 608) zu der ersten Schaltplatinenoberfläche (411) und der zweiten Schalplatinenoberfläche (412) senkrecht ausgerichtet werden, wodurch wenigstens ein Streifen (410, 602) von Sockeln erzeugt wird, der sich entlang eines Teils der Breite der Rückwand oder entlang der vollen Breite der Rückwand in einer Richtung senkrecht zu der ersten Schaltplatinenoberfläche (411) und der zweiten Schaltplatinenoberfläche (412) erstreckt.

## Revendications

1. Fond de panier (406, 61) pour un magasin (401), le fond de panier comprenant une première surface de fond de panier (609) et une seconde surface de fond de panier opposée (610), le fond de panier étant équipé de connecteurs femelles (407, 504, 603) sur la première surface du fond de panier (609), les connecteurs femelles ayant un certain nombre de points de contact (604, 703) et étant agencés pour recevoir un connecteur mâle de couplage (409, 501), montée sur le bord arrière d'un ensemble carte de circuit (408) pour établir un contact électrique entre l'ensemble carte de circuit et le fond de panier, l'ensemble carte de circuit ayant une certaine largeur et comportant une première surface de carte de circuit (411) et une seconde surface opposée de carte de circuit (412) les deux surfaces de carte de circuit étant perpendiculaires au fond de panier, et les connecteurs femelles étant agencés en outre de sorte à réaliser des rangées (605) des points de contacts qui sont perpendiculaires à la première surface de carte de circuit (411) et à la seconde surface de carte de circuit (412), les connecteurs femelles (407, 504, 603) comportant des extrémités en circuit ouvert (606) et deux parois latérales (607, 608) le long de chaque côté longitudinal du connecteur femelle et au moins une rangée de broches de connecteur (605) entre les parois latérales (607, 608), **caractérisé en ce que** les connecteurs femelles sont montés extrémité courte à extrémité courte, les parois latérales étant alignées perpendiculairement à la première surface de carte de circuit (411) et à la seconde surface de carte de circuit (412), créant ainsi au moins une bande (410, 602) de connecteurs femelles dans la direction perpendiculaire à la première surface de carte de circuit (411) et à la seconde surface de carte de circuit (412).

2. Fond de panier selon la revendication 1, **caractérisé en ce que** l'au moins une bande (410, 602) de connecteurs femelles s'étend le long d'une partie de la largeur (611) du fond de panier ou le long de la totalité de la largeur du fond de panier.

3. Fond de panier selon la revendication 1 ou 2, **caractérisé en ce qu'**il existe une distance égale entre les points de contact (604, 703) dans la direction perpendiculaire à la première surface de carte de circuit (411) et à la seconde surface de carte de circuit (412).

4. Fond de panier selon l'une quelconque des revendications 1 à 3, **caractérisé en ce que** les points de contact (604, 703) dans les connecteurs femelles (407, 504, 603) sont réalisés en tant que contacts mâles ou broches de contact.

5. Fond de panier selon l'une quelconque des revendications 1 à 3, **caractérisé en ce que** les points de contact (604, 703) dans les connecteurs femelles (407, 504, 603) sont réalisés en tant que contacts femelles.

6. Fond de panier selon l'une quelconque des revendications précédentes, **caractérisé en ce que** la largeur des assemblages de carte de circuit (408) dans un magasin (401) peut varier dans les limites d'un multiple d'un espacement sélectionné, qui est la largeur de base de l'ensemble carte de circuit.

7. Fond de panier selon l'une quelconque des revendications précédentes, **caractérisé en ce que** les positions des cartes (801 à 813, 900 à 907) pour deux cartes de commutation de communication sont allouées au milieu du magasin, l'une d'entre elles étant redondante.

8. Fond de panier selon la revendication 7, **caractérisé en ce que** les cartes de communication sont réalisées selon la norme Ethernet.

9. Fond de panier selon l'une quelconque des revendications précédentes, **caractérisé en ce que** les connecteurs mâles (409, 501) comportent des arêtes (502) sur chaque côté, perpendiculaires à la première surface de carte de circuit (411) et à la seconde surface de carte de circuit (412) qui sont adaptées à être couplées avec des connecteurs femelles correspondants (503) sur les côtés intérieurs des parois latérales (607, 108) vers le connecteur femelle (407, 504, 603).

10. Fond de panier selon l'une quelconque des revendications précédentes, **caractérisé en ce que** l'alimentation des assemblages de carte de circuit (408) est agencée en connectant deux rangées (701) et (702) des broches de connecteur (604, 703) avec des bandes larges (704, 705) d'un matériau conducteur, chaque bande reliant une rangée de broches de connecteur.

11. Fond de panier selon la revendication 10, **caractérisé en ce que** le matériau conducteur est du cuivre.

12. Fond de panier selon l'une quelconque des revendications précédentes, **caractérisé en ce qu'**une connexion IPMI vers les assemblages de carte de circuit (408) est agencée en connectant deux rangées (605) des broches de connecteur (604, 703) avec des bandes d'un matériau conducteur, chaque bande reliant une rangée de broches de connecteur.

13. Magasin (401) **caractérisé en ce qu'**il est équipé d'un fond de panier (406, 601) selon l'une quelconque des revendications précédentes.

14. Procédé d'agencement (1001) de connecteurs femelles (407, 504, 603) sur un fond de panier (406, 601), **caractérisé en ce que** les connecteurs femelles sont montés (1002) extrémité courte (606) à extrémité courte avec des parois latérales (607, 608) alignées perpendiculairement (1003) à la première surface de carte de circuit (411) et à la seconde surface de carte de circuit (412) créant ainsi au moins une bande (410, 602) de connecteurs femelles, s'étendant le long d'une partie de la largeur du fond de panier ou le long de la totalité de la largeur du fond de panier, dans une direction perpendiculaire à la première surface de carte de circuit (411) et à la seconde surface de carte de circuit (412).
